Europäisches Patentamt

**European Patent Office**

Office européen des brevets

(11) Numéro de publication: **0 275 000**

**A2**

## (12) DEMANDE DE BREVET EUROPEEN

(21) Numéro de dépôt: **87870202.6**

(22) Date de dépôt: **24.12.87**

(51) Int. Cl.⁴ **G01F 15/06**

(30) Priorité: **12.01.87 BE 8700008**

(43) Date de publication de la demande:
**20.07.88 Bulletin 88/29**

(84) Etats contractants désignés:
**AT BE CH DE FR GB IT LI LU NL SE**

(71) Demandeur: **S.A. AQUACOM
rue de Magnée 110
B-4610 Beyne-Heusay(BE)**

(72) Inventeur: **Lenfant, Théo
rue Rotenberg 55
B-4700 Eupen(BE)**

(74) Mandataire: **Dellicour, Paul
Office de Brevets E. Dellicour rue Fabry
18/012
B-4000 Liège(BE)**

(54) **Perfectionnement aux compteurs donneurs d'impulsion pour eau, gaz, électricité.**

(57) Le système de montage consiste à intercaler dans le champ magnétique entre l'aimant (1), actionnant le totalisateur mécanique, et le détecteur magnétique (2) un aimant-relais tournant (3). Le détecteur magnétique (2) surmontant l'aimant-relais (3) est inséré dans un capteur (5) et celui-ci est logé dans le doigt de gant courant (6) du compteur (7).

FIG.2

EP 0 275 000 A2

## Perfectionnement aux compteurs donneurs d'impulsions pour eau, gaz, électricité

La présente invention est relative aux compteurs donneurs d'impulsions applicable aux fluides, tels que eau, gaz ou électricité.

Suivant l'état actuel de la technique ce type d'appareil comporte un aimant qui, fixé sur un disque et passant devant un détecteur, enclenche ce dernier. Pour qu'il soit capable d'actionner ledit détecteur, l'aimant doit être placé à une faible distance de celui-ci, ce qui provoque une possibilité de fraude du totalisateur numérique actionné par l'aimant.

Pour obvier à cet inconvénient il a paru avantageux de créer un système de montage, qui empêche toute fraudabilité.

Un système de montage réalisé suivant l'invention consiste à intercaler dans le champ magnétique entre l'aimant, actionnant le totalisateur mécanique, et le détecteur magnétique un aimant-relais roulant. Ce qui permet de disposer le détecteur à une distance relativement grande de l'aimant par rapport aux montages habituels.

Suivant l'invention le détecteur surmontant l'aimantrelais est disposé dans un capteur conformé pour être logé dans un doigt de gant courant.

L'invention est décrite maintenant avec plus de détails sur la base des dessins annexés, à titre d'exemple uniquement, montrant en :

Figure 1 le schéma de principe du montage suivant l'invention ;

Figure 2 une coupe transversale dans un compteur donneur d'impulsion suivant l'invention, et

Figure 3 une coupe transversale dans le capteur renfermant le détecteur magnétique et l'aimant-relais.

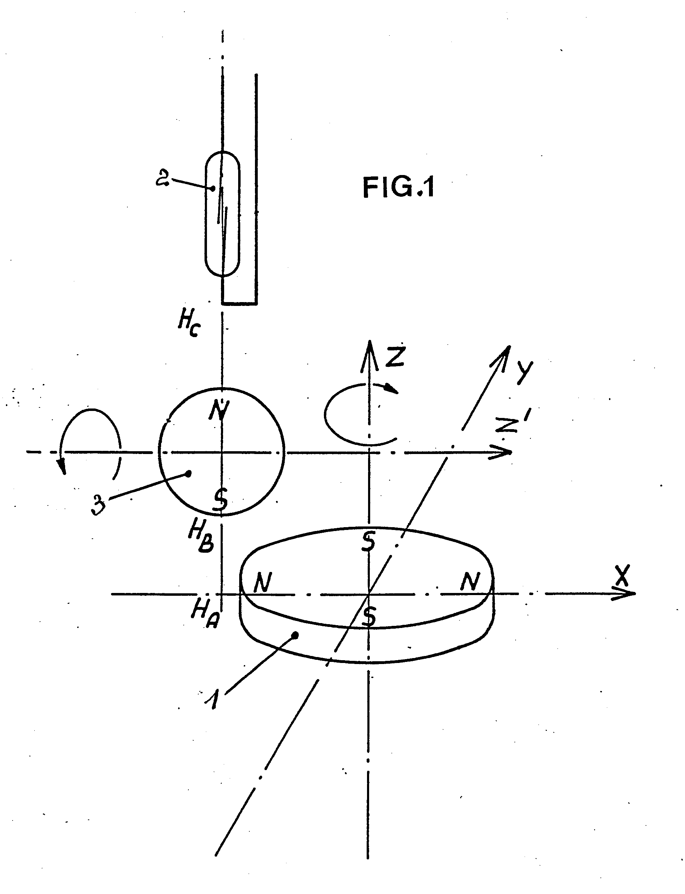

On a représenté en figure 1 le schéma de principe du montage suivant l'invention. On voit en 1 le disque ou aimant destiné à actionner le détecteur magnétique 2 et tournant dans le sens de la flèche sur l'axe Z.

Le champ magnétique HA n'est capable d'actionner le détecteur 2 que s'il est placé à une faible distance dudit détecteur. Si on éloigne le détecteur au-delà de cette faible distance, il ne détecte plus ce champ magnétique.

Suivant l'invention on place un aimant-relais 3, de manière que le champ magnétique HA de l'aimant 1 puisse le faire tourner dans le sens de la flèche sur l'axe Z' et de manière que son propre champ magnétique HB soit fort assez pour actionner le détecteur magnétique 2 (champ magnétique HC).

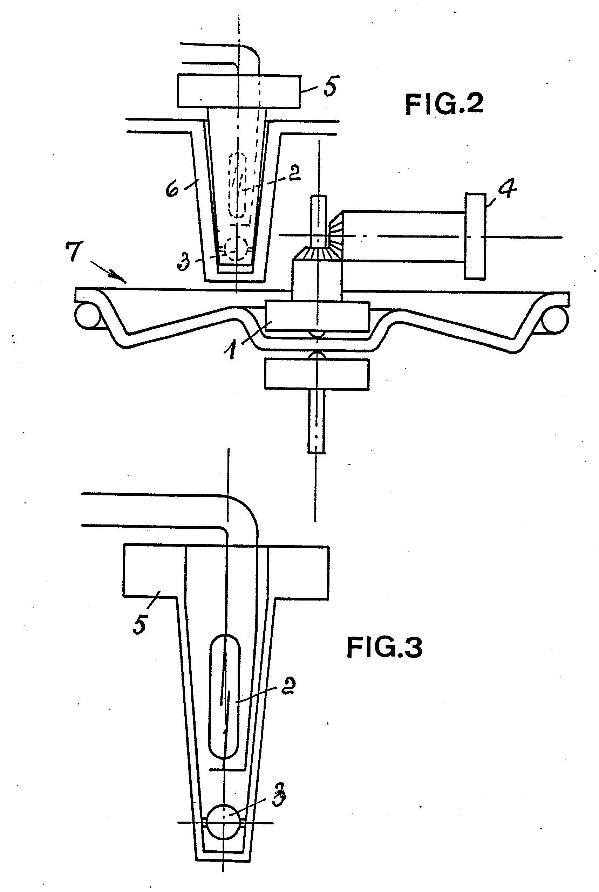

Ce montage permet la non-fraudabilité du totalisateur mécanique actionné au départ de l'organe 4 par l'aimant 1 (figure 2). En effet, on peut bloquer l'aimant-relais 3 sans pour cela freiner exagérément l'aimant 1 ; celui-ci se verra freiné pendant un quart de révolution puis accéléré lors du quart de révolution suivant et l'influence sur le résultat de mesure lors de débits métrologiques sera négligeable.

Une réalisation du montage suivant l'invention consiste à insérer dans un capteur 5 le détecteur 2 surmontant l'aimant-relais 3, constitué a. antageusement par exemple par une sphère, et à loger ledit capteur 5 dans le doigt de gant courant 6 du compteur (figure 2).

## Revendications

1. Système de montage d'un compteur donneur d'impulsions pour eau, gaz ou électricité, caractérisé en ce qu'il consiste à intercaler dans le champ magnétique entre l'aimant (1), actionnant le totalisateur mécanique, et le détecteur magnétique (2) un aimant-relais tournant (3).

2. Système de montage suivant la revendication 1, caractérisé en ce qu'il consiste à insérer le détecteur magnétique (2) surmontant l'aimant-relais (3) dans un capteur (5) et à loger ledit capteur (5) dans le doigt de gant courant (6) du compteur (7).

3. Système de montage suivant l'une quelconque des revendications 1 et 2, caractérisé en ce que l'aimantrelais (3) est constitué par une sphère.

FIG.1

0 275 000

FIG.2

FIG.3